# EUROPÄISCHE PATENTSCHRIFT

(11) **EP 3 448 135 B1**
(45) Veröffentlichungstag und Bekanntmachung des Hinweises auf die Patenterteilung: **08.11.2023**
(21) Anmeldenummer: 18190454.1
(22) Anmeldetag: 23.08.2018
(51) Int. Cl.: H05K 1/02, H01R 13/6587, H01R 13/518, H01R 12/72, H05K 1/11, H01R 12/70

(54) **STECKER, STECKERBUCHSE UND ENTSPRECHENDES VERBINDUNGSSYSTEM**
CONNECTOR, SOCKET AND CORRESPONDING CONNECTION SYSTEM
FICHE, DOUILLE ENFICHABLE ET SYSTÈME DE RACCORD CORRESPONDANT

(30) Priorität: 25.08.2017 DE 102017008087; 25.08.2017 DE 102017008065
(43) Veröffentlichungstag der Anmeldung: 27.02.2019
(73) Patentinhaber: Yamaichi Electronics Deutschland GmbH, 85609 Aschheim-Dornach (DE)
(72) Erfinder: Quiter, Michael, 57482 Wenden (DE); Serrano, Jaime Fernández, 80796 München (DE); Michel, Dirk, 85778 Haimhausen (DE)
(74) Vertreter: Müller-Boré & Partner Patentanwälte PartG mbB

(56) Entgegenhaltungen:
- EP-A1- 3 163 689
- US-A- 4 451 107
- US-A1- 2013 217 263

## Beschreibung

Die Erfindung betrifft ein Stecker zum Verbinden mit einer Steckerbuchse und ein System zum Herstellen einer elektrischen Verbindung, bestehend aus einem Stecker und einer Steckerbuchse.

Moderne Kraftfahrzeuge werden mit einem Zentralrechner ausgestattet, der diverse Automotive Anwendungen ausführen bzw. steuern kann. Dazu kann der Zentralrechner des Kraftfahrzeugs wie bei einem Mainboard eines PCs oder Notebooks mit einer Leiterplatte bzw. einem Printed Circuit Board (PCB) verbunden werden, die für die jeweilige Anwendung spezifisch ist. Die Verbindung zwischen dem Zentralrechner und der Leiterplatte wird beispielsweise mit einem Verbindungssystem, bestehend aus einem Stecker und einer Steckerbuchse, realisiert. Dabei werden mittels des Verbindungssystems zwischen dem Zentralrechner und der Leiterplatte elektrische Differenzsignale zur Datenverarbeitung ausgetauscht.

Bisher bekannte Stecker zum Übertragen der elektrischen Differenzsignale weisen in der Regel zumindest ein Kontaktpaar auf, welches mit einem komplementären Kontaktpaar einer Steckerbuchse elektrisch verbunden wird. Beim Übertragen von elektrischen Signalen unter Nutzung von elektrischen Differenzsignalen, ergibt sich der Signalwert des elektrischen Signals aus dem Spannungs- und/oder Stromunterschied der an dem Kontaktpaar anliegenden elektrischen Signale.

Häufig treten bei der Übertragung von Differenzsignalen Gleichtaktstörungen auf. Durch die Gleichtaktstörung können auf den Kontakten des Kontaktpaares Störspannungen und/oder -ströme auftreten, welche eine gleiche Phasenlage und gleiche Amplitude aufweisen. Zur Stromrückführung ist in der Regel jedem Kontaktpaar ein weiteres separates Kontaktelement zugeordnet, welches mit einem elektrischen Bezugspotential verbunden ist. Eine solche Anordnung hat jedoch den Nachteil, dass bei einer Vielzahl von Kontaktpaaren für jedes Kontaktpaar jeweils ein separates Kontaktelement zur Stromrückführung benötigt wird. Dadurch benötigen Stecker mit einer Vielzahl von Kontaktpaaren ein großes Volumen bzw. viel Platz. Des Weiteren ist die Montage besagter Stecker an einer elektrischen Baugruppe aufwendig, da jedes Kontaktelement zur Stromrückführung mit der elektrischen Baugruppe verbunden bzw. verlötet werden muss.

Ferner ist aus der US 2013/217263 A1 eine elektrische Verbinderanordnung bekannt, die mehrere gestapelte Wafer umfasst. Jeder Wafer enthält eine leitende Platte, die mehrere Schlitze darin definiert, und mehrere Kontaktmodule, die jeweils in einem der Schlitze aufgenommen werden. Die Leiterplatte besteht aus Kunststoff, der zur Verbesserung der Abschirmungsleistung mit einer Metallbeschichtung versehen ist. Jedes der Kontaktmodule umfasst ein Kontaktpaar und einen isolierenden Halter, der das Kontaktpaar an der Leiterplatte befestigt. Die isolierende Halterung ist entlang der Kontaktpaare unterschiedlich ausgehöhlt, um die Impedanz zu verbessern.

EP 3 163 689 A1 bezieht sich auf eine Netzwerkverbinderanordnung für Fahrzeuge, wobei das Netzwerk vorzugsweise mit Datenraten von 100 Mbit/s und/oder 1 Gbit/s kommuniziert und wobei eine Steckverbinderanordnung einen Header umfasst, umfassend mindestens zwei Stifte, die ein Stiftpaar bilden, wobei sich die Stifte in einer Verbindungsrichtung erstrecken. Ein elektrisch leitendes Abschirmelement schirmt das Stiftpaar an mindestens zwei Seiten ab und weist eine Vorderseite auf, die im Wesentlichen normal zur Verbindungsrichtung ausgerichtet ist.

Es ist daher die Aufgabe der vorliegenden Erfindung, einen Stecker bereitzustellen, welcher dazu geeignet ist, Differenzsignale zu übertragen, wobei der Stecker kompakt ausgebildet werden kann und einfach zu montieren ist.

Diese Aufgabe wird durch die Gegenstände der unabhängigen Ansprüche gelöst. Bevorzugte Ausführungsformen sind in den abhängigen Ansprüchen definiert.

Ein Aspekt der Erfindung betrifft ein Stecker nach Anspruch 1.

Der Steckersockel ist bevorzugt flach bzw. dünn ausgebildet und weist eine längliche Struktur auf, an der die Vielzahl von steckerseitigen Differential-Pair Kontaktelementen angeordnet ist. Dabei kann die Vielzahl von steckerseitigen Differential-Pair Kontaktelementen in Richtung einer Verbindungsrichtung an dem Steckersockel angeordnet bzw. ausgerichtet sein. Als "Verbindungsrichtung" ist die Richtung zu verstehen, in welche der Stecker zum Verbinden mit der Steckerbuchse bewegt wird. Insbesondere können der Steckersockel und die Vielzahl von steckerseitigen Differential-Pair Kontaktelementen voneinander elektrisch isoliert ausgebildet sein. Beispielsweise kann jedes steckerseitige Differential-Pair Kontaktelement der Vielzahl von steckerseitigen Differential-Pair Kontaktelementen mit einem zugehörigen steckerseitigen Differential-Pair Isolierkörper an dem Steckersockel angeordnet werden. Ein solcher steckerseitiger Differential-Pair Isolierkörper kann aus einem dielektrischen Material wie Kunststoff bestehen, um das steckerseitige Differential-Pair Kontaktelement elektrisch von dem Steckersockel zu isolieren.

Erfindungsgemäß weist der Steckersockel eine Vielzahl von steckerseitigen Differential-Pair Kontakthohlräumen auf, wobei jeder steckerseitige Differential-Pair Kontakthohlraum dazu ausgebildet ist, jeweils einen steckerseitigen Differential-Pair Isolierkörper mit einem daran angeordneten steckerseitigen Differential-Pair Kontaktelement aufzunehmen. Die Anzahl von steckerseitigen Differential-Pair Kontakthohlräumen entspricht vorzugsweise der Anzahl von vorgesehenen Differential-Pair Kontaktelementen. Ferner ist jeder steckerseitige Differential-Pair Kontakthohlraum als ein im Wesentlichen rechteckiger Kanal ausgebildet, welcher sich in Verbindungsrichtung durch den Steckersockel erstreckt. Vorzugsweise ist die Vielzahl von steckerseitigen Differential-Pair Kontaktelementen voneinander elektrisch isoliert an dem Steckersockel angeordnet. Zur Übertragung des Differenzsignals kann jedes steckerseitige Differential-Pair Kontaktelement der Vielzahl von steckerseitigen Differential-Pair Kontaktelementen ein erstes elektrisch leitendes Verbindungselement und ein zweites elektrisch leitendes Verbindungselement aufweisen, wobei vorgesehen ist, das erste elektrisch leitende Verbindungselement zur Übertragung eines ersten elektrischen Signals des Differenzsignals zu nutzen und das zweite elektrisch leitende Verbindungselement zur Übertragung eines zweiten elektrischen Signals des Differenzsignals zu nutzen. Der Signalwert des elektrischen Differenzsignals bestimmt sich aus der Spannungs- und/oder Stromdifferenz des ersten elektrischen Signals und des zweiten elektrischen Signals.

Vorzugsweise ist vorgesehen, dass die Vielzahl von steckerseitigen Differential-Pair Kontaktelementen jeweils unterschiedliche Differenzsignale übertragen und/oder mehrere steckerseitige Differential-Pair Kontaktelemente das gleiche Differenzsignal übertragen. Bevorzugt ist die Vielzahl von steckerseitigen Differential-Pair Kontaktelementen dazu ausgebildet, Differenzsignale in einem Bereich von +2V bis -2V zu übertragen. Die vorliegende Erfindung ist jedoch nicht ausschließlich auf diesen Bereich beschränkt. So kann vorgesehen sein, die steckerseitigen Differential-Pair Kontaktelemente derart auszubilden, Differenzsignale in einem Bereich von 0V bis 60V, in einem Bereich von 1V bis 12V oder in einem Bereich von 1V-2V zu übertragen.

Vorzugsweise kann der Stecker an einer kraftfahrzeugseitigen elektrischen Baugruppe angeordnet bzw. montiert werden. Alternativ kann der Stecker an einer mit dem Kraftfahrzeug zu verbindenden elektrischen Baugruppe, beispielsweise einer Leiterplatte, angeordnet bzw. montiert werden. Zur Herstellung der elektrischen Verbindung zwischen dem zumindest einen Bezugspotentialkontaktelement und dem Bezugspotential kann auf der kraftfahrzeugseitigen Baugruppe ein elektrisches Bezugspotential vorgesehen werden. Als elektrisches Bezugspotenzial kann zum Beispiel ein Masse- bzw. Erdungsanschluss dienen.

In einer bevorzugten Ausführungsform sind das erste elektrisch leitende Verbindungselement und das zweite elektrisch leitende Verbindungselement sämtlicher steckerseitigen Differential-Pair Kontaktelemente der Vielzahl von steckerseitigen Differential-Pair Kontaktelementen als Pins ausgebildet. Dabei können die Längsachsen der ersten elektrisch leitenden Verbindungselemente und der zweiten elektrisch leitenden Verbindungselemente parallel zueinander ausgebildet sein, wobei die Längsachsen der ersten elektrisch leitenden Verbindungselemente und der zweiten elektrisch leitenden Verbindungselemente somit im Wesentlichen parallel zur Verbindungsrichtung ausgebildet sind. Ferner können die Längsachsen der ersten elektrisch leitenden Verbindungselemente und der zweiten elektrisch leitenden Verbindungselemente senkrecht zum Steckersockel angeordnet sein.

Vorzugsweise weist die Vielzahl von steckerseitigen Differential-Pair Kontaktelementen eine matrixförmige Anordnung, aufgeteilt in Reihen aus Differential-Pair Kontaktelementen und Spalten aus Differential-Pair Kontaktelementen, auf. Bevorzugt sind die Reihen von Differential-Pair Kontaktelementen parallel zueinander ausgebildet. Ebenso können die Spalten von Differential-Pair Kontaktelementen parallel zueinander ausgebildet sein, wobei die Spalten orthogonal zu den Reihen angeordnet sind. Alternativ kann die matrixförmige Anordnung der Vielzahl von steckerseitigen Differential-Pair Kontaktelementen auch aus mindestens einer Reihe von steckerseitigen Differential-Pair Kontaktelementen und aus mindestens zwei Spalten von steckerseitigen Differential-Pair Kontaktelementen bestehen. Bevorzugt verlaufen die Reihen von steckerseitigen Differential-Pair Kontaktelementen parallel zur länglichen Ausrichtung des Steckersockels.

Vorzugsweise sind alle steckerseitigen Differential-Pair Kontaktelemente der Vielzahl von steckerseitigen Differential-Pair Kontaktelementen in der matrixförmigen Anordnung der Vielzahl von steckerseitigen Differential-Pair Kontaktelementen uniform ausgerichtet. Insbesondere sind die jeweils durch das erste elektrisch leitende Verbindungselement und das zweite elektrisch leitende Verbindungselement eines jeden Differential-Pair Kontaktelements aufgespannten Ausrichtungsebenen bzw. Bezugsebenen parallel zueinander ausgerichtet, wobei die Ausrichtungsebenen bzw. Bezugsebenen im Wesentlichen parallel zur Verbindungsrichtung angeordnet sind.

Bei einer Montage bzw. Anordnung des Steckers an der kraftfahrzeugseitigen Baugruppe kann vorgesehen sein, dass das zumindest eine Bezugspotentialkontaktelement elektrisch mit dem auf der kraftfahrzeugseitigen Baugruppe vorgesehenen Bezugspotential elektrisch verbunden ist.

Bei einer Montage bzw. Anordnung des Steckers an der mit dem Kraftfahrzeug zu verbindenden elektrischen Baugruppe, kann vorgesehen sein, dass die elektrische Verbindung zu dem Bezugspotential über die kraftfahrzeugseitig montierte Steckerbuchse erfolgt, wobei in diesem Fall das zumindest eine Bezugspotentialkontaktelement elektrisch mit der Steckerbuchse verbunden ist. Dafür kann das zumindest eine elektrisch leitende Bezugspotentialkontaktelement dazu ausgebildet sein, in einem montierten Zustand bzw. Verbindungszustand des Steckers, d.h. in einem Zustand in dem der Stecker mit der Steckerbuchse verbunden ist, eine elektrische Verbindung mit der Steckerbuchse herzustellen.

Vorzugsweise ist das zumindest eine Bezugspotentialkontaktelement dazu ausgebildet, einen Rückstrom für die Vielzahl von steckerseitigen Differential-Pair Kontaktelementen hin zum Bezugspotential zu führen bzw. zu leiten. Das Führen des Rückstroms wird insbesondere durch die elektrische Verbindung zwischen dem zumindest einen Bezugspotentialkontaktelement und dem Bezugspotenzial erreicht. Dabei ist insbesondere vorgesehen, dass das zumindest eine Bezugspotentialkontaktelement für alle Kontaktelemente der Vielzahl von steckerseitigen Differential-Pair Kontaktelementen zum Führen des Rückstroms ausgebildet ist. Somit kann auf separate Bezugspotentialkontaktelemente zur Stromrückführung eines jeden steckerseitigen Differential-Pair Kontaktelements der Vielzahl von steckerseitigen Differential-Pair Kontaktelementen verzichtet werden. Mit anderen Worten sind außer dem zumindest einen Bezugspotentialkontaktelement keine weiteren Stromrückführungselemente vorgesehen. Folglich kann die Baugröße bzw. die Abmessung des Steckers reduziert werden. Darüber hinaus kann die kraftfahrzeugseitige Montage des Steckers oder die Montage des Steckers an der Leiterplatte durch den Wegfall von separaten Bezugspotentialkontaktelementen vereinfacht werden, da durch die weggefallenen separaten Bezugspotentialkontaktelemente weniger Elemente kraftfahrzeugseitig bzw. leiterplattenseitig montiert werden müssen.

Erfindungsgemäß ist der Steckersockel als Zinkdruckguss-Bauteil ausgebildet und die Vielzahl von steckerseitigen Differential-Pair Kontaktelementen ist von dem Steckersockel mittels der zuvor beschriebenen steckerseitigen Differential-Pair Isolierkörper elektrisch isoliert ausgebildet. Durch die Ausbildung des Steckersockels als Zinkdruckguss-Bauteil kann der Steckersockel besonders stabil ausgebildet werden. Ferner lässt sich der Steckersockel somit preiswert und einfach herstellen.

Gemäß der Erfindung ist der Steckersockel dazu ausgebildet, mit dem elektrischen Bezugspotential elektrisch verbunden zu werden, wobei das zumindest eine Bezugspotentialkontaktelement mit dem Steckersockel elektrisch verbunden ist. Somit wird das zumindest einen Bezugspotentialkontaktelement mittels des Steckersockels mit dem elektrischen Bezugspotenzial verbunden. Dadurch wird eine einfachere Montage des Steckers an einer Leiterplatte ermöglicht, da ein kraftfahrzeugseitiges Befestigen des Bezugspotentialkontaktelements oder ein Befestigen des Bezugspotentialkontaktelements an der Leiterplatte entfallen kann.

In einer bevorzugten Ausführungsform kann der Stecker mehrere Bezugspotentialkontaktelemente aufweisen, welche die zuvor genannten Eigenschaften des zumindest einen Bezugspotentialkontaktelements aufweisen. Insbesondere weist der Stecker ein erstes Bezugspotentialkontaktelement und/oder ein zweites Bezugspotentialkontaktelement und/oder ein drittes Bezugspotentialkontaktelement auf.

Ferner kann das erste Bezugspotentialkontaktelement zumindest teilweise plattenförmig ausgebildet sein. Bevorzugt ist das erste Bezugspotentialkontaktelement mit dem Steckersockel verbindbar bzw. lösbar ausgebildet.

Insbesondere können an dem ersten Bezugspotentialkontaktelement Verbindungsflächen vorgesehen sein, welche zum (unmittelbaren) elektrischen Verbinden des Bezugspotentialkontaktelements mit dem Bezugspotenzial dienen. Dazu kann vorgesehen sein, dass die Verbindungsflächen des ersten Bezugspotentialkontaktelements mit entsprechenden Verbindungspunkten an der kraftfahrzeugseitigen Baugruppe, welche mit dem Bezugspotential verbunden sind, elektrisch verbunden werden. Eine solche Verbindung kann zum Beispiel durch Reflow-löten bzw. Pin-in-paste-löten erfolgen.

Erfindungsgemäß ist das erste Bezugspotentialkontaktelement als Blechbauteil, insbesondere als Stanzblechbauteil, ausgebildet.

Dadurch wird eine einfache und preiswerte Fertigung des ersten Bezugspotentialkontaktelements gewährleistet. Des Weiteren weist das Blechbauteil bzw. Stanzblechbauteil federnde Eigenschaften auf, welche zum Verbinden des Blechbauteils bzw. Stanzblechbauteils mit dem Steckersockel bzw. der Steckerbbuchse genutzt werden können (siehe unten).

Des Weiteren kann ein erster Abschnitt bzw. eine erste Verbindungsfläche des bevorzugt als Blechbauteil bzw. Stanzblechbauteil ausgebildeten ersten Bezugspotentialkontaktelements zumindest teilweise parallel zu einer durch das erste elektrisch leitende Verbindungselement und das zweite elektrisch leitende Verbindungselement aufgespannten Bezugsebene bzw. Ausrichtungsebene ausgebildet sein. Dabei können das erste Bezugspotentialkontaktelement und die Vielzahl von steckerseitigen Differential-Pair Kontaktelementen so dimensioniert sein, dass beim Verbinden des Steckers mit der Steckerbuchse, das erste Bezugspotentialkontaktelement zuerst in Kontakt mit der Steckerbuchse gelangt bevor die Vielzahl von steckerseitigen Differential-Pair Kontaktelementen in Kontakt mit der Steckerbuchse gelangt. Insbesondere kann das bevorzugt als Blechbauteil bzw. Stanzblechbauteil ausgebildete erste Bezugspotentialkontaktelement sich ausgehend vom Steckersockel in Verbindungsrichtung weiter bzw. höher erstrecken als die Vielzahl von steckerseitigen Differential-Pair Kontaktelementen. Das erste Bezugspotentialkontaktelement kann somit beim Verbinden von Stecker und Steckerbuchse als Führung dienen, um ein einfaches Verbinden des Steckers mit der Steckerbuchse zu ermöglichen.

Des Weiteren kann ein zweiter Abschnitt bzw. eine zweite Verbindungsfläche des bevorzugt als Blechbauteil bzw. Stanzblechbauteil ausgebildeten ersten Bezugspotentialkontaktelements zumindest teilweise senkrecht zu der durch das erste elektrisch leitende Verbindungselement und das zweite elektrisch leitende Verbindungselement aufgespannten Bezugsebene bzw. Ausrichtungsebene ausgebildet sein.

In einer bevorzugten Ausführungsform ist das erste Bezugspotentialkontaktelement parallel zu einer Reihe aus steckerseitigen Differential-Pair Kontaktelementen und/oder parallel zu einer Spalte aus steckerseitigen Differential-Pair Kontaktelementen angeordnet. Für den Fall, dass das erste Bezugspotentialkontaktelement parallel zu einer Reihe aus steckerseitigen Differential-Pair Kontaktelementen angeordnet ist, kann das erste Bezugspotentialkontaktelement eine Länge aufweisen, welche mindestens der Länge der Reihe aus steckerseitigen Differential-Pair Kontaktelementen entspricht. Für den Fall, dass das erste Bezugspotentialkontaktelement parallel zu einer Spalte aus steckerseitigen Differential-Pair Kontaktelementen angeordnet ist, kann das erste Bezugspotentialkontaktelement eine Länge aufweisen, welche mindestens der Länge der Spalte aus steckerseitigen Differential-Pair Kontaktelementen entspricht. Vorzugsweise ist das erste Bezugspotentialkontaktelement als elektrische Abschirmung der Vielzahl von steckerseitigen Differential-Pair Kontaktelementen ausgebildet. Durch die Ausbildung des ersten Bezugspotentialkontaktelements als Abschirmung, kann der Einfluss von Störsignalen auf die Vielzahl von steckerseitigen Differential-Pair Kontaktelementen reduziert werden. Dazu kann vorgesehen sein, dass das erste Bezugspotentialkontaktelement die Vielzahl von steckerseitigen Differential-Pair Kontaktelementen bzw. die matrixförmige Anordnung der Vielzahl von steckerseitigen Differential-Pair Kontaktelementen umgibt. Vorzugsweise kann das als Blechbauteil bzw. Stanzblechbauteil ausgebildete erste Bezugspotentialkontaktelement entsprechend der matrixförmigen Anordnung der Vielzahl von steckerseitigen Differential-Pair Kontaktelementen mehrfach abgekantet ausgebildet sein, wobei benachbarte abgekantete Verbindungsflächen bzw. Abschnitte im Wesentlichen rechtwinklig zueinanderstehen. Somit kann das erste Bezugspotentialkontaktelement käfigförmig bzw. zaunförmig ausgebildet sein, wobei die Vielzahl von steckerseitigen Differential-Pair Kontaktelementen von dem ersten Bezugspotentialkontaktelement umgeben ist und somit im Inneren des ersten Bezugspotentialkontaktelements angeordnet ist.

Erfindungsgemäß weist das erste Bezugspotentialkontaktelement Verrastungselemente zum formschlüssigen Verbinden des ersten Bezugspotentialkontaktelements mit dem Steckersockel auf. Das erste Bezugspotentialkontaktelement kann derart ausgebildet sein, dass die Verrastungselemente mit einem Randbereich des Steckersockels in Eingriff gelangen. Des Weiteren sind an dem Steckersockel korrespondierende bzw. komplementäre Aufnahmeelemente vorgesehen, welche mit den Verrastungselementen in Eingriff gelangen. Somit kann auf einfache Weise das erste Bezugspotentialkontaktelement mit dem Steckersockel verbunden bzw. wieder gelöst werden.

Des Weiteren kann das erste Bezugspotentialkontaktelement Federelemente zum kraftschlüssigen Verbinden des ersten Bezugspotentialkontaktelements mit der Steckerbuchse aufweisen. Die Federelemente können derart ausgebildet sein, dass die Federelemente im verbundenen Zustand des Steckers und der Steckerbuchse eine Klemm- bzw. Haltewirkung auf die Steckerbuchse entfalten. Dadurch wird ein Lösen der Verbindung zwischen Stecker und Steckerbuchse wirksam verhindert. Insbesondere können bei einer Ausgestaltung des ersten Bezugspotentialkontaktelements, bei der das erste Bezugspotentialkontaktelement die Vielzahl von steckerseitigen Differential-Pair Kontaktelementen umgibt, die Federelemente auf sich gegenüberliegenden (Verbindungs)-Flächen bzw. Seiten des ersten Bezugspotentialkontaktelements ausgebildet sein. Im verbundenen Zustand von Stecker und Steckerbuchse ist die Steckerbuchse zwischen diesen Federelementen angeordnet bzw. eingeklemmt.

In einer bevorzugten Ausführungsform können das zweite Bezugspotentialkontaktelement und der Steckersockel zusammen einstückig ausgebildet sind. Mit anderen Worten ist das zweite Bezugspotentialkontaktelement Bestandteil des Steckers bzw. Steckersockels. Dabei kann der Stecker mit dem enthaltenen zweiten Bezugspotentialkontaktelement im Zinkdruckguss-Verfahren hergestellt werden. Ferner kann das zweite Bezugspotentialkontaktelement, im montierten Zustand von Stecker und Steckerbuchse, an einer der Steckerbuchse gegenüberliegenden Seite des Steckersockels ausgebildet sein. Das zweite Bezugspotentialkontaktelement kann eine steckerseitige Vielzahl von Kontaktflächen aufweisen, welche dazu ausgebildet ist, im montierten Zustand von Steckersockel und Steckerbuchse, in an der Steckerbuchse vorgesehenen komplementären Aussparrungen angeordnet zu werden. Im montierten Zustand von Steckersockel und Steckerbuchse kontaktiert die steckerseitige Vielzahl von Kontaktflächen die Steckebuchse, so dass auf diesem Weg eine elektrische Verbindung zwischen Steckersockel und der Steckerbuchse besteht. Mit anderen Worten liegt im montierten Zustand von Stecker und Steckerbuchse die Vielzahl von Kontaktflächen an der Steckerbuchse an.

Vorzugsweise ist das zweite Bezugspotentialkontaktelement derart ausgebildet, dass jedem steckerseitigen Differential-Pair Kontaktelement bzw. jedem steckerseitigen Differential-Pair Kontakthohlraum jeweils zwei verschiedene steckerseitige Kontaktflächen der steckerseitigen Vielzahl von Kontaktflächen zugeordnet sind. Eine erste steckerseitige Kontaktfläche der zwei verschiedenen steckerseitigen Kontaktflächen ist vorzugsweise parallel zu der durch das erste elektrisch leitende Verbindungselement und das zweite elektrisch leitende Verbindungselement aufgespannten Bezugsebene angeordnet. Ferner ist eine zweite steckerseitige Kontaktfläche der zwei verschiedenen steckerseitigen Kontaktflächen senkrecht zu der zuvor genannten Bezugsebene ausgebildet, so dass die zwei verschiedenen steckerseitigen Kontaktflächen ebenfalls senkrecht zueinander angeordnet sind. Ferner können jedem steckerseitigen Differential-Pair Kontaktelement genau zwei unterschiedliche steckerseitige Kontaktflächen zugeordnet sein, wobei jedem steckerseitigen Differential-Pair Kontaktelement ein unterschiedliches Paar von steckerseitigen Kontaktflächen zugeordnet ist.

Vorzugsweise sind die zwei verschiedenen Kontaktflächen derart an dem Steckersockel angeordnet, dass die zwei verschiedenen Kontaktflächen sich dem jeweiligen zugeordneten steckerseitigen Differential-Pair Kontakthohlraum in Verbindungsrichtung anschließen. Somit ist es möglich das zweite Bezugspotentialkontaktelement möglichst nah bzw. dicht an der Vielzahl von Steckerseitigen Differential-Pair Kontaktelementen auszubilden. Dadurch kann der durch das zweite Bezugspotentialkontaktelement geführte Rückstrom möglichst dicht bzw. nah an der Vielzahl von steckerseitigen Differential-Pair Kontaktelementen geführt werden, was die Qualität der Signalübertragung verbessert.

Vorzugsweise sind die zwei verschiedenen Kontaktflächen derart ausgebildet, dass im montierten Zustand des Steckers und der Steckerbuchse, die zwei verschiedenen Kontaktflächen zusammen mit zwei steckerbuchsenseitigen Kontaktflächen, welche jeweils einem zu dem steckerseitigen Differential-Pair Kontaktelement entsprechenden steckerbuchsenseitigen Differential-Pair Kontaktelement zugeordnet sind, einen Verbindungskanal bilden. Dabei umgibt der Verbindungskanal das steckerseitige Differential-Pair Kontaktelement und das komplementäre steckerbuchsenseitige Differential-Pair Kontaktelement, welche ein Differential-Pair Kontaktpaar bilden. Ferner erstreckt sich der Verbindungskanal entlang der Verbindungsrichtung. Folglich ist es möglich den Rückstrom möglichst nah bzw. dicht an dem Differential-Pair Kontaktpaar zu führen, so dass sich die Übertragungsqualität verbessert.

In einer bevorzugten Ausführungsform ist das dritte Bezugspotentialkontaktelement einstückig mit dem Stecker bzw. Steckersockel ausgebildet und ist somit Bestandteil des Steckers. Ferner kann der Stecker im Zinkdruckguss-Verfahren gefertigt werden, wobei während des Herstellungsverfahrens das zweite Bezugspotentialkontaktelement und/oder das dritte Bezugspotentialkontaktelement mit dem Stecker einstückig ausgebildet werden.

Das dritte Bezugspotentialkontaktelement kann insbesondere als Sicherungselement ausgebildet sein, um die Steckerbuchse im Verbundenen Zustand von Stecker und Steckerbuchse an dem Stecker zu sichern. Zum Sichern der Steckerbuchse an dem Stecker, kann das dritte Bezugspotentialkontaktelement in Eingriff mit einem an der Steckerbuchse vorhandenen Sicherungselement gelangen. Dazu kann das dritte Bezugspotentialkontaktelement ein erstes Sicherungselement und ein zweites Sicherungselement aufweisen, wobei jeweils eins der Sicherungselemente an den in länglicher Richtung des Steckersockels befindlichen Enden des Steckersockels angeordnet ist. Dabei erstrecken sich das erste Sicherungselement und das zweite Sicherungselement jeweils ausgehend von dem Steckersockel in Richtung der Verbindungsrichtung.

Ein weiterer nicht beanspruchter Aspekt der Erfindung betrifft ein elektrisches Modul zur Verwendung in einem Kraftfahrzeug, aufweisend:
- eine elektrische Baugruppe; und
- einen Stecker gemäß den obigen Ausführungen, wobei die Vielzahl von steckerseitigen Differential-Pair Kontaktelementen und das Bezugspotentialkontaktelement jeweils elektrisch leitend mit der elektrischen Baugruppe verbunden ist.

Insbesondere kann die elektrische Baugruppe eine kraftfahrzeugseitige elektrische Baugruppe, beispielsweise ein BUS-System oder eine Signalverarbeitungseinrichtung, sein. Des Weiteren kann die elektrische Baugruppe auch eine mit dem Kraftfahrzeug elektrisch verbindbare Baugruppe sein, welche bevorzugt mit der fahrzeugseitigen Baugruppe verbunden werden kann. Eine solche Baugruppe kann beispielswiese eine Leiterplatte bzw. ein PCB umfassen, an der/dem diverse elektrische Komponenten angeordnet sind. Dabei kann vorgesehen sein, dass bei einer Anordnung des Steckers an der kraftfahrzeugseitigen elektrischen Baugruppe, das Bezugspotentialkontaktelement mit einem an der kraftfahrzeugseitigen elektrischen Baugruppe bereitgestellten Bezugspotential elektrisch verbunden ist. Des Weiteren kann die Vielzahl von steckerseitigen Differential-Pair Kontaktelementen mit an der kraftfahrzeugseitigen Baugruppe angeordneten elektrischen Komponenten elektrisch verbunden sein.

Bei einer Anordnung des Steckers an der mit dem Kraftfahrzeug verbindbaren Baugruppe, kann das Bezugspotentialkontaktelement dazu ausgebildet sein, in einem verbundenen Zustand der beiden Baugruppen, elektrisch mit dem kraftfahrzeugseitigen Bezugspotential verbunden zu werden. Dazu kann das Bezugspotentialkontaktelement in elektrischen Kontakt mit einer mit dem Stecker verbundenen Steckerbuchse stehen, wobei die Steckerbuchse eine elektrische Verbindung zu dem Bezugspotential aufweist.

Ein weiterer Aspekt der Erfindung betrifft ein Verbindungssystem zum Herstellen einer elektrischen Verbindung zur Verwendung in einem Kraftfahrzeug, aufweisend:
- einen Stecker gemäß den obigen Ausführungen; und
- eine mit dem Stecker verbindbare Steckerbuchse, wobei die Steckerbuchse eine zu der Vielzahl von steckerseitigen Differential-Pair Kontaktelementen entsprechende Vielzahl von steckerbuchsenseitigen Differential-Pair Kontaktelementen aufweist, und
wobei ein von der Vielzahl von steckerbuchsenseitigen Differential-Pair Kontaktelementen elektrisch isoliertes Gehäuse der Steckerbuchse dazu ausgebildet ist, elektrisch mit dem ersten Bezugspotentialkontaktelement verbunden zu sein.

Vorzugsweise ist das Gehäuse der Steckerbuchse als Zinkdruckgussbauteil ausgebildet. Des Weiteren ist vorgesehen, dass jedem steckerbuchsenseitigen Differential-Pair Kontaktelement zwei steckerbuchsenseitige Kontaktflächen zugeordnet sind, wobei die zwei steckerbuchsenseitigen Kontaktflächen und das Gehäuse der Steckerbuchse einstückig ausgebildet sind. Im verbundenen bzw. montierten Zustand des Steckers und der Steckerbuchse, bilden die zwei steckerbuchsenseitige Kontaktflächen mit den an dem Stecker entsprechend angeordneten zwei verschiedenen steckerseitigen Kontaktflächen den oben erwähnten Verbindungskanal.

### Figurenbeschreibung

Nachfolgend wird eine bevorzugte Ausführungsform der Erfindung anhand der beigefügten Figuren beispielhaft erläutert.
**Figur 1** zeigt eine perspektivische Ansicht eines erfindungsgemäßen Steckers.
**Figur 2** zeigt eine weitere perspektivische Ansicht eines erfindungsgemäßen Steckers.
**Figur 3** zeigt eine Vorderansicht auf einen erfindungsgemäßen Stecker.
**Figur 4** zeigt eine weitere perspektivische Ansicht eines erfindungsgemäßen Steckers.
**Figur 5** zeigt eine Steckerbuchse gemäß der vorliegenden Erfindung.
**Figur 6** zeigt einen erfindungsgemäßen Stecker und eine Steckerbuchse beim Verbinden.

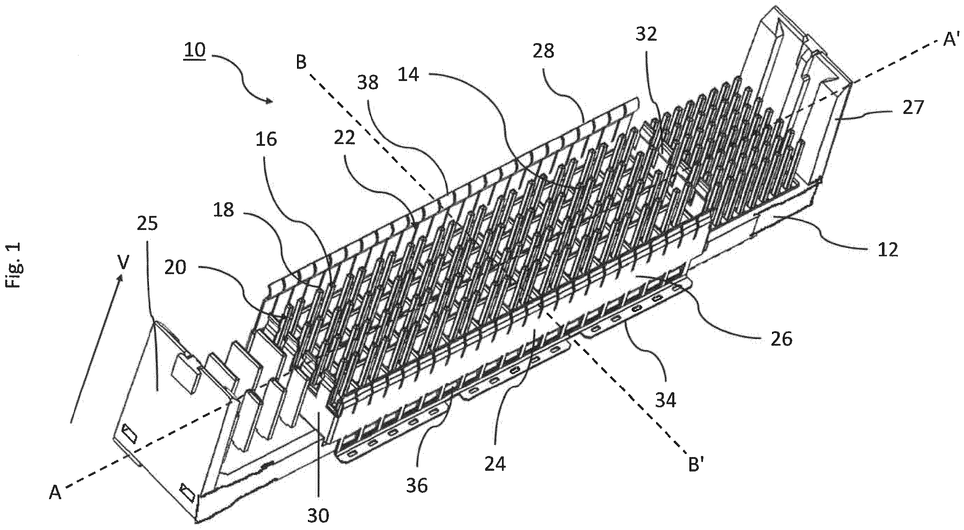

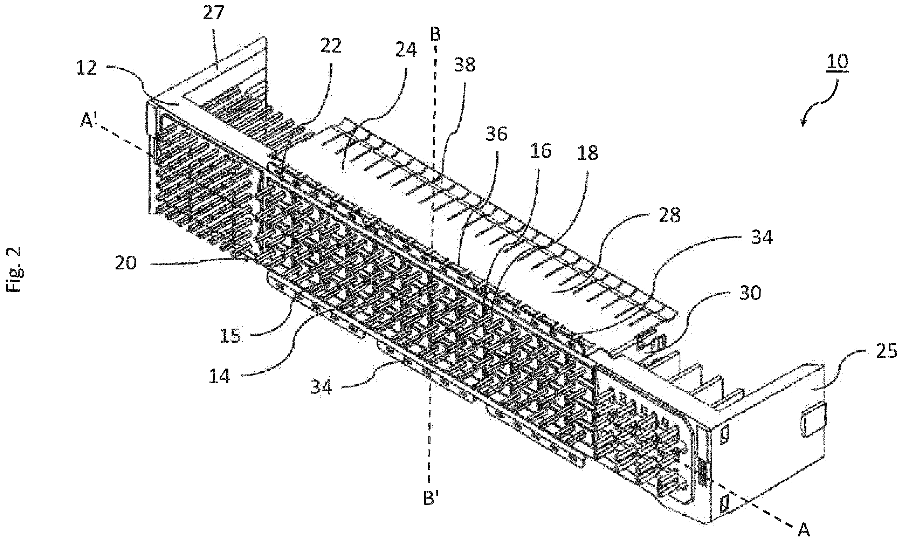

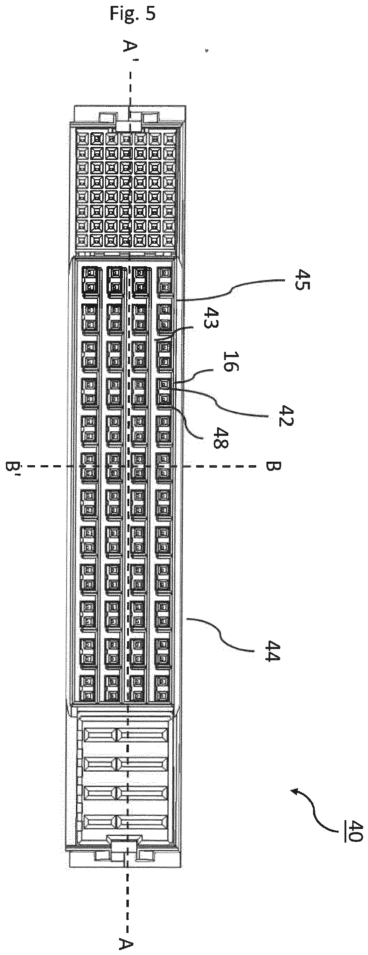

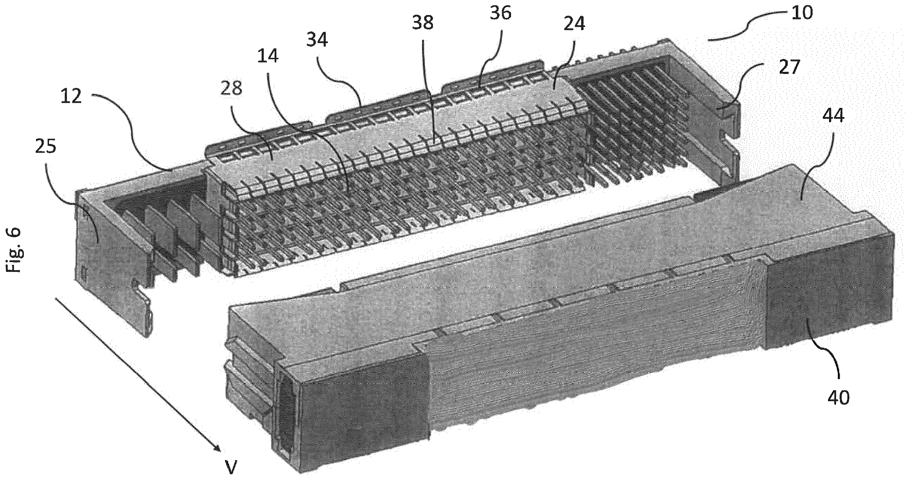

**Fig. 1** **und** **2** zeigen eine perspektivische Ansicht des erfindungsgemäßen Steckers 10, wobei Fig. 1 die Vorderseite des Steckers 10 darstellt und Fig. 2 die Rückseite des Steckers 10 darstellt. Der Stecker 10 kann in Richtung der gezeigten Verbindungsrichtung V mit einer komplementären Steckerbuchse 40 (siehe Fig.5 und 6) verbunden werden. Der Stecker 10 besteht aus einem Steckersockel 12, welcher eine längliche, flache Struktur aufweist. Fig. 1 zeigt, wie sich der Steckersockel 12 entlang der A-A'-Linie in Längsrichtung erstreckt. Des Weiteren erstreckt sich der Steckersockel 12 quer zur Längsrichtung A-A' entlang der in Fig. 1 dargestellten B-B'-Linie bzw. Querrichtung. Bevorzugt verlaufen die Querrichtung B-B' und die Längsrichtung A-A' jeweils senkrecht zur Verbindungsrichtung V. Der Stecker 10 bzw. der Steckersockel 12 ist vorzugsweise als Zinkdruckgussbauteil ausgebildet.

An dem Steckersockel 12 ist eine Vielzahl von steckerseitigen Differential-Pair Kontaktelementen 14 ausgebildet. Die Vielzahl von steckerseitigen Differential-Pair Kontaktelementen 14 ist dazu vorgesehen, eine elektrische Verbindung mit einer Steckerbuchse 40, beispielsweise der in den **Figuren 5** **und** **6** gezeigten Steckerbuchse 40 herzustellen.

Wie in **Fig. 5** gezeigt, weist die Steckerbuchse 40 eine Vielzahl von steckerbuchsenseitigen Differential-Pair Kontaktelementen 42 auf, welche elektrisch mit der Vielzahl von steckerseitigen Differential-Pair Kontaktelementen 14 verbunden werden kann. Dabei ist für jedes steckerseitige Differential-Pair Kontaktelement 14 ein komplementäres bzw. entsprechendes steckerbuchsenseitiges Differential-Pair Kontaktelement 42 vorgesehen. Ein steckerseitiges Differential-Pair Kontaktelementen 14 und ein komplementäres bzw. entsprechendes steckerbuchsenseitiges Differential-Pair Kontaktelement 42 bilden dabei ein Differential-Pair Kontaktpaar.

Der Steckersockel 12 kann insbesondere als Träger der Vielzahl von steckerseitigen Differential-Pair Kontaktelementen 14 vorgesehen werden. Insbesondere ist der Steckersockel 12 von der Vielzahl von steckerseitigen Differential-Pair Kontaktelementen 14 elektrisch isoliert ausgebildet. Dazu kann vorgesehen werden, dass jedes steckerseitige Differential-Pair Kontaktelement 14 der Vielzahl von steckerseitigen Differential-Pair Kontaktelementen 14 an dem Steckersockel 12 mittels eines steckerseitigen Differential-Pair Isolierkörpers 15 angeordnet ist. Der steckerseitige Differential-Pair Isolierkörper 15 kann aus einem dielektrischen Material, z.B. Kunststoff gefertigt sein.

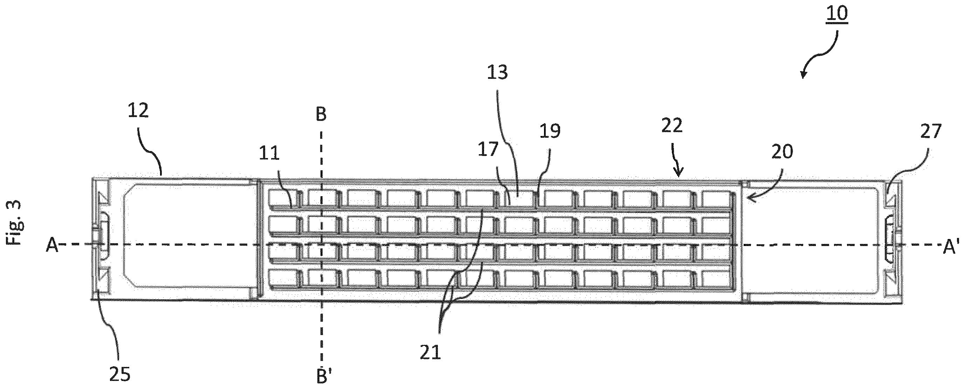

**Fig. 3** zeigt eine Vorderansicht des erfindungsgemäßen Steckers 10, wobei die Betrachtung entgegengesetzt zur Verbindungsrichtung V erfolgt. Wie in Fig. 3 gezeigt, weist der Steckersockel 12 eine Vielzahl von steckerseitigen Kontakthohlräumen 13 auf, wobei jeder steckerseitige Kontakthohlraum 13 dazu ausgebildet ist, genau ein steckerseitiges Differential-Pair Kontaktelement 14 aufzunehmen. Insbesondere ist vorgesehen, dass jeder steckerseitige Kontakthohlraum 13 genau einen steckerseitigen Differential-Pair Isolierkörper 15 mit einem daran angeordneten steckerseitigen Differential-Pair Kontaktelement 14 aufnimmt, um den Steckersockel 12 von dem steckerseitigen Differential-Pair Kontaktelementen 14 elektrisch zu isolieren. Erfindungsgemäß ist jeder steckerseitige Kontakthohlraum 13 im Wesentlichen als ein Kanal mit rechteckigem Querschnitt ausgebildet, wobei sich der Kanal entlang der Verbindungsrichtung durch den Steckersockel 12 erstreckt.

Jedes steckerseitige Differential-Pair Kontaktelement 14 der Vielzahl von steckerseitigen Differential-Pair Kontaktelementen 14 kann dazu ausgebildet sein, ein elektrisches Differenzsignal zu führen bzw. zu leiten. Insbesondere kann jedes steckerseitige Differential-Pair Kontaktelement 14 der Vielzahl von steckerseitigen Differential-Pair Kontaktelementen 14 ein erstes elektrisches Verbindungselement 16 und ein zweites elektrisches Verbindungselement 18 aufweisen, welche jeweils eine Signalkomponente des Differenzsignals leiten bzw. führen.

Des Weiteren können das erste elektrische Verbindungselement 16 und das zweite elektrisch Verbindungselement 18 als Pins ausgebildet. Wie in Fig. 1 dargestellt, ist die Längsachse eines Pins der Vielzahl von steckerseitigen Differential-Pair Kontaktelementen 14 senkrecht zum Steckersockel 12 bzw. senkrecht zu einer durch die A-A'-Linie und B-B'-Linie aufgespannten Fläche angeordnet. Mit anderen Worten verläuft die Längsachse der Pins parallel zur Verbindungsrichtung V. Die Vielzahl von steckerseitigen Differential-Pair Kontaktelementen 14 bzw. das erste elektrische Verbindungselement 16 und das zweite elektrische Verbindungselement 18 können aus eine Kupferlegierung gefertigt sein.

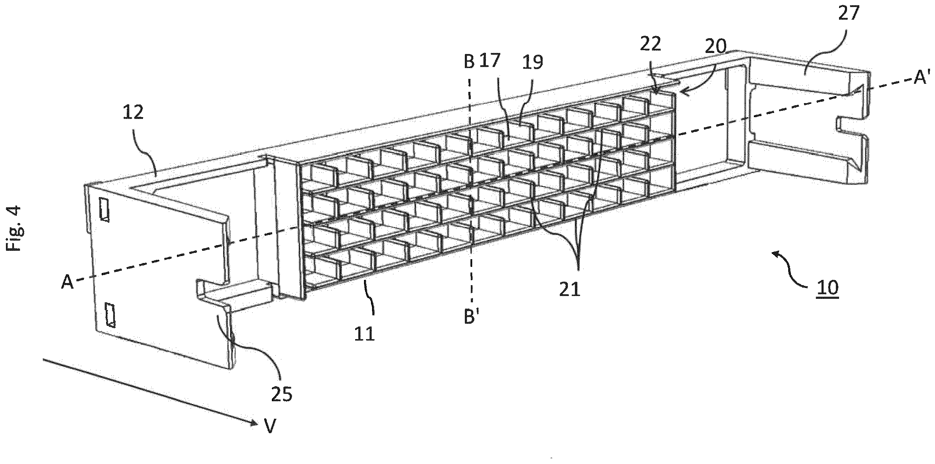

Wie in Fig. 1 und Fig. 2 gezeigt, ist die Vielzahl von steckerseitigen Differential-Pair Kontaktelementen 14 matrixförmig angeordnet, so dass die Vielzahl von steckerseitigen Differential-Pair Kontaktelementen 14 aus Reihen von steckerseitigen Differential-Pair Kontaktelementen 20 und Spalten von steckerseitigen Differential-Pair Kontaktelementen 22 besteht. Entsprechend der matrixförmigen Anordnung der Vielzahl von steckerseitigen Differential-Pair Kontaktelementen 14 ist die Vielzahl von steckerseitigen Kontakthohlräumen 13 matrixförmig an dem Steckersockel 12 angeordnet (siehe Fig. 3 und 4).

Vorzugsweise erstrecken sich die Reihen von steckerseitigen Differential-Pair Kontaktelementen 20 parallel zur Längsrichtung des Steckersockels 12 bzw. parallel zur A-A'-Linie. Des Weiteren erstrecken sich die Spalten von steckerseitigen Differential-Pair Kontaktelementen 22 parallel zur B-B'-Linie bzw. senkrecht zu den Reihen von steckerseitigen Differential-Pair Kontaktelementen 20. Wie in Fig. 1 gezeigt, weist der Stecker 10 vier Reihen von steckerseitigen Differential-Pair Kontaktelementen 20 auf und zwölf Spalten von steckerseitigen Differential-Pair Kontaktelementen 22 auf. Dabei ist die Vielzahl von steckerseitigen Differential-Pair Kontaktelementen 14 uniform ausgerichtet. D.h. die durch das erste elektrische Verbindungselement 16 und das zweite elektrischen Verbindungselement 18 eines jeden steckerseitigen Differential-Pair Kontaktelements 14 aufgespannten Bezugsebenen sind parallel zueinander ausgerichtet.

Des Weiteren ist an dem Steckersockel 12 ein erstes Bezugspotentialkontaktelement 24 angeordnet. Das erste Bezugspotentialkontaktelement 24 ist dazu ausgelegt, mit einem elektrischen Bezugspotential verbunden zu werden. Das elektrische Bezugspotential kann über eine nicht gezeigte elektrische Baugruppe zur Verfügung gestellt werden.

Das erste Bezugspotentialkontaktelement 24 ist plattenförmig ausgebildet und umgibt die matrixförmige Anordnung der Vielzahl von steckerseitigen Differential-Pair Kontaktelementen 14. Dabei kann das erste Bezugspotentialkontaktelement 24 insbesondere als Blechbauteil bzw. Stanzblechbauteil ausgebildet werden. Wie in Fig. 1 gezeigt weist das erste Bezugspotentialkontaktelement 24 vier Seiten bzw. Flächen auf, die die Vielzahl von steckerseitigen Differential-Pair Kontaktelementen 14 umgeben. Eine erste Seite des ersten Bezugspotentialkontaktelements 26 und eine zweite Seite des ersten Bezugspotentialkontaktelements 28 sind gegenüberliegend angeordnet und erstrecken sich parallel zur Längsrichtung des Steckersockels 12 bzw. parallel zur gezeigten A-A' Linie. Dabei ist die Vielzahl von steckerseitigen Differential-Pair Kontaktelementen 14 zwischen der ersten Seite des ersten Bezugspotentialkontaktelements 26 und der zweiten Seite des ersten Bezugspotentialkontaktelements 28 angeordnet.

Des Weiteren weist das erste Bezugspotentialkontaktelement 24 eine dritte Seite 30 und eine vierte Seite 32 auf. Die dritte Seite des ersten Bezugspotentialkontaktelements 30 und die vierte Seite des ersten Bezugspotentialkontaktelements 32 sind parallel zueinander angeordnet und erstrecken sich jeweils senkrecht zur Längsrichtung des Steckersockels 12 bzw. senkrecht zur A-A'-Linie. Mit anderen Worten erstrecken sich die dritte Seite des ersten Bezugspotentialkontaktelements 30 und die vierte Seite des ersten Bezugspotentialkontaktelements 32 parallel zur B-B' Linie bzw. Querrichtung. Dabei ist die Vielzahl von steckerseitigen Differential-Pair Kontaktelementen 14 zwischen der dritten Seite des ersten Bezugspotentialkontaktelements 30 und der vierten Seite des ersten Bezugspotentialkontaktelements 32 angeordnet. Die dritte Seite des ersten Bezugspotentialkontaktelements 32 verbindet ein erstes Ende der ersten Seite des ersten Bezugspotentialkontaktelements 26 mit einem ersten Ende der zweiten Seite des ersten Bezugspotentialkontaktelements 28 und die vierte Seite des ersten Bezugspotentialkontaktelements 32 verbindet ein zweites Ende der ersten Seite des ersten Bezugspotentialkontaktelements 26 mit einem zweiten Ende der zweiten Seite des ersten Bezugspotentialkontaktelements 28. Dadurch weist das erste Bezugspotentialkontaktelement 24 eine zaunförmige Struktur auf, die die Vielzahl von steckerseitigen Differential-Pair Kontaktelementen 14 und insbesondere die matrixförmige Anordnung der Vielzahl von steckerseitigen Differential-Pair Kontaktelementen 14 umgibt.

Des Weiteren weist das erste Bezugspotentialkontaktelement 24 Verbindungsflächen 34 auf, welche an der ersten Seite des ersten Bezugspotentialkontaktelements 26 und/oder zweiten Seite des ersten Bezugspotentialkontaktelements 28 angeordnet sind. Die Verbindungsflächen 34 können dazu ausgelegt sein, das erste Bezugspotentialkontaktelement 24 mit dem auf der elektrischen Baugruppe bereitgestellten Bezugspotential elektrisch zu verbinden. Dabei können die Verbindungsflächen 34 rechtwinklig von der ersten Seite des ersten Bezugspotentialkontaktelements 26 und/oder von der zweiten Seite des ersten Bezugspotentialkontaktelements 28 abgewinkelt ausgebildet sein. Des Weiteren kann vorgesehen werden, dass die Verbindungsflächen 34 dazu ausgebildet sind, mit der elektrischen Baugruppe verbunden zu werden, um das erste Bezugspotentialkontaktelement 24 an der elektrischen Baugruppe (mechanisch) zu befestigen. Dadurch kann der Steckersockel 12 zwischen der elektrischen Baugruppe und dem ersten Bezugspotentialkontaktelement 24 fixiert bzw. eingeklemmt werden, wodurch der Steckersockel 12 bzw. der Stecker 10 stabil an der elektrischen Baugruppe montiert werden kann.

Die elektrische Verbindung des ersten Bezugspotentialkontaktelements 24 mit dem Bezugspotential kann entweder direkt, mittels einer entsprechenden Verbindung des ersten Bezugspotentialkontaktelements 24 mit einem auf der elektrischen Baugruppe vorgesehenen Verbindungspunkt, welcher mit dem Bezugspotential verbunden ist, vorgesehen werden, oder der Steckersockel 12 bzw. der Stecker 10 kann mit dem Bezugspotential elektrisch verbunden sein, wobei das erste Bezugspotentialkontaktelement 24 wiederum mit dem Stecker 10 bzw. dem Steckersockel 12 elektrisch verbunden sein kann.

Wie oben beschrieben, kann das erste Bezugspotentialkontaktelement 24 dazu vorgesehen sein, einen Rückstrom hin zum Bezugspotential für die durch die Vielzahl von steckerseitigen Differential-Pair Kontaktelementen 14 geführten Differenzsignale zu leiten. Dabei können die Vielzahl von steckerseitigen Differential-Pair Kontaktelementen 14 dazu ausgebildet sein, verschiedene Differenzsignale oder auch teilweise dieselben Differenzsignale zu leiten. Es ist somit vorgesehen, dass das erste Bezugspotentialkontaktelement 24 für alle steckerseitigen Differential-Pair Kontaktelemente der Vielzahl von steckerseitigen Differential-Pair Kontaktelementen 14 eine gemeinsame Stromrückführung hin zum Bezugspotential bereitstellt. Somit entfällt ein für jedes steckerseitige Differential-Pair Kontaktelement vorgesehenes separates Bezugspotentialkontaktelement zum Führen des Rückstroms. Der Stecker 10 kann somit kompakter gefertigt werden. Aufgrund einer geringeren Anzahl von benötigten Verdrahtungen, lässt sich der Stecker 10 mit geringerem Aufwand an einer Baugruppe montieren.

Des Weiteren weist das erste Bezugspotentialkontaktelement 24 Verrastungselemente 36 auf, welche an der ersten Seite des ersten Bezugspotentialkontaktelements 26 und an der zweiten Seite des ersten Bezugspotentialkontaktelements 28 angeordnet sind. Die Verrastungselemente 34 sind dazu ausgebildet, eine formschlüssige Verbindung mit dem Steckersockel 12 einzugehen, wenn das erste Bezugspotentialkontaktelement 24 an dem Stecker 10 bzw. Steckersockel 12 angeordnet ist. Dabei können die Verrastungselemente 34 mit an dem Steckersockel 12 außenseitig vorgesehenen komplementären Gegenrasten in Eingriff gelangen. Durch die Verrastungselemente 34 lässt sich das erste Bezugspotentialkontaktelement 24 besonders einfach und schnell an dem Stecker 10 bzw. dem Steckersockel 12 montieren.

Des Weiteren weist das erste Bezugspotentialkontaktelement 24 Federelemente 38 auf, welche dazu ausgebildet sind, das Bezugspotentialkontaktelement 24 mit der Steckerbuchse 40 kraftschlüssig zu verbinden, wenn die Steckerbuchse 40 mit dem Stecker 10 verbunden ist. Die Federelemente 38 können dabei auf gegenüberliegenden Seiten des ersten Bezugspotentialkontaktelements 24 ausgebildet sein. Wie in Fig. 1 dargestellt, sind die Federelemente 38 auf der ersten bis vierten Seite des ersten Bezugspotentialkontaktelements 24 ausgebildet. Die Federelemente 38 sind dazu ausgebildet, eine von dem ersten Bezugspotentialkontaktelement 24 nach innen gerichtete Federkraft auszuüben, um im verbundenen Zustand eine Kraft auf die Steckerbuchse 40 auszuüben. Das erste Bezugspotentialkontaktelement 24 umgibt im verbundenen Zustand zumindest teilweise die Steckerbuchse 40.

Des Weiteren kann das erste Bezugspotentialkontaktelement 24 derart ausgebildet sein, dass beim Verbinden des Steckers 10 mit der Steckerbuchse 40, das erste Bezugspotentialkontaktelement 24 die Steckerbuchse 40 kontaktiert bevor die Vielzahl von steckerseitigen Differential-Pair Kontaktelementen 14 in Kontakt mit der Vielzahl von steckerbuchsenseitigen Differential-Pair Kontaktelementen 42 gelangt. Insbesondere kann, bezogen auf den Steckersockel 12, das erste Bezugspotentialkontaktelement 24 höher (in Richtung der Verbindungsrichtung V) ausgebildet sein, als die Vielzahl von steckerseitigen Differential-Pair Kontaktelementen 14. Beim Verbinden des Steckers 10 mit der Steckerbuchse 40 fungiert das erste Bezugspotentialkontaktelement 24 somit als Führung für die Steckerbuchse 40, wodurch sich der Stecker 10 und die Steckerbuchse 40 einfacher verbinden lassen.

Des Weiteren zeigen **Fig. 3** **und** **4** ein am Steckersockel 12 angeordnetes zweites Bezugspotentialkontaktelement 11, welches sich ausgehend vom Steckersockel 12 in Richtung der Verbindungsrichtung V erstreckt. Das zweite Bezugspotentialkontaktelement 11 weist eine steckerseitige Vielzahl von Kontaktflächen auf, wobei jedem steckerseitigen Differential-Pair Kontaktelement 14 jeweils eine erste steckerseitige Kontaktfläche 17 und eine zweite steckerseitige Kontaktfläche 19 der steckerseitigen Vielzahl von Kontaktflächen zugeordnet ist. Insbesondere sind jedem steckerseitigen Differential-Pair Kontaktelement 14 genau zwei verschiedene steckerseitige Kontaktflächen der steckerseitigen Vielzahl von Kontaktflächen zugeordnet. Die erste steckerseitige Kontaktfläche 17 und die zweite steckerseitige Kontaktfläche 19 sind im Wesentlichen senkrecht zueinander angeordnet, wobei die erste steckerseitige Kontaktfläche 17 parallel zu der durch das erste elektrische Verbindungselement 16 und durch das zweite elektrische Verbindungselement 18 aufgespannten Bezugsebene angeordnet ist. Vorzugsweise erstrecken sich die erste steckerseitige Kontaktfläche 17 und die zweite steckerseitige Kontaktfläche 19 ausgehend von dem steckerseitigen Kontakthohlraum 13 in Richtung der Verbindungsrichtung V.

Vorzugsweise ist das zweite Bezugspotentialkontaktelement 11 dazu ausgelegt, in eine steckerbuchsenseitige Aussparung 43 einzugreifen, wenn der Stecker 10 mit der Steckerbuchse 40 verbunden ist. Insbesondere ist die steckerseitige Vielzahl von Kontaktflächen dazu ausgebildet, in die steckerbuchsenseitige Aussparung 43 einzugreifen, so dass im verbundenen Zustand von Stecker 10 und Steckerbuchse 40, die steckerseitige Vielzahl von Kontaktflächen die Steckerbuchse 40 kontaktiert. Dadurch kann die Steckerbuchse 40 mit dem Stecker 10 elektrische verbunden werden.

**Fig. 5** zeigt eine Vorderansicht der mit dem Stecker 10 verbindbaren Steckerbuchse 40. Die Steckerbuchse 40 weist ein Gehäuse 44 auf, welches in einem montierten bzw. verbundenen Zustand des Steckers 10 und der Steckerbuchse 40 in elektrischen Kontakt mit dem ersten Bezugspotentialkontaktelement 24 und/oder mit dem zweiten Bezugspotentialkontaktelement 11 steht.

Wie in Fig. 5 gezeigt, sind die Vielzahl von steckerbuchsenseitigen Differential-Pair Kontaktelementen 42 der Steckerbuchse 40 matrixförmig, entsprechend der matrixförmigen Anordnung der Vielzahl von steckerseitigen Differential-Pair Kontaktelementen 14, angeordnet. Jedes steckerseitige Differential-Pair Kontaktelement 14 der Vielzahl von steckerseitigen Differential-Pair Kontaktelementen 14 ist dazu ausgelegt, mit einem korrespondierenden bzw. komplementären steckerbuchsenseitigen Differential-Pair Kontaktelement 42 der Vielzahl von steckerbuchsenseitigen Differential-Pair Kontaktelementen 42 verbunden bzw. gekoppelt zu werden, um ein elektrisches Signal und insbesondere ein Differenzsignal zu übertragen. Dabei kann eine Signalübertragung und insbesondere eine Übertragung eines Differenzsignals von dem Stecker 10 zur Steckerbuchse 40 oder von der Steckerbuchse 40 zum Stecker 10 hin erfolgen.

Des Weiteren zeigt Fig. 5 eine steckerbuchsenseitige Vielzahl von Kontaktflächen 45, welche sich entgegen der Verbindungsrichtung V erstrecken. Ähnlich der steckerseitigen Vielzahl von Kontaktflächen 21, sind jedem steckerbuchsenseitigen Differential-Pair Kontaktelementen 42 jeweils zwei verschiedene steckerbuchsenseitige Kontaktflächen, eine erste steckerbuchsenseitige Kontaktfläche 46 und eine zweite steckerbuchsenseitige Kontaktfläche 48, der steckerbuchsenseitigen Vielzahl von Kontaktflächen 45 zugeordnet. Ferner können jedem steckerbuchsenseitigen Differential-Pair Kontaktelement genau zwei steckerbuchsenseitige Kontaktflächen zugeordnet sein.

Im verbundenen Zustand von Stecker 10 und Steckerbuchse 40, ist die erste steckerbuchsenseitige Kontaktfläche 46 parallel zu der von dem ersten elektrischen Verbindungselement 16 und dem zweiten elektrischen Verbindungselement 18 aufgespannten Bezugsebene ausgebildet. Des Weiteren sind die erste steckerbuchsenseitige Kontaktfläche 46 und die zweite steckerbuchsenseitige Kontaktfläche 48 senkrecht zueinander ausgebildet.

Im Folgenden wird die Anordnung der ersten steckerseitigen Kontaktfläche 17, der zweiten steckerseitigen Kontaktfläche 19, der ersten steckerbuchsenseitigen Kontaktfläche 46 und der zweiten steckerbuchsenseitigen Kontaktfläche 44, welche einem steckerseitigen Differential-Pair Kontaktelement 14 bzw. einem komplementären steckerbuchsenseitigen Differential-Pair Kontaktelement 42 zugeordnet sind, beschrieben. Das steckerseitige Differential-Pair Kontaktelement 14 und das komplementäre steckerbuchsenseitige Differential-Pair Kontaktelement 42 bilden ein Differential-Pair Kontaktpaar. Im verbundenen Zustand von Stecker 10 und Steckerbuchse 40, sind die einem steckerseitigen Differential-Pair Kontaktelement 14 zugeordnete erste steckerseitige Kontaktfläche 17 und die einem komplementären steckerbuchsenseitigen Differential-Pair Kontaktelement 42 zugeordnete erste steckerbuchsenseitige Kontaktfläche 46 parallel zueinander angeordnet. Ferner ist das zugeordnete Differential-Pair Kontaktpaar zwischen der ersten steckerseitigen Kontaktfläche 17 und der erste steckerbuchsenseitigen Kontaktfläche 46 angeordnet.

Des Weiteren sind, im verbundenen Zustand von Stecker 10 und Steckerbuchse 40, die einem steckerseitigen Differential-Pair Kontaktelement 14 zugeordnete zweite steckerseitige Kontaktfläche 19 und die einem komplementären steckerbuchsenseitigen Differential-Pair Kontaktelement 42 zugeordnete zweite steckerbuchsenseitige Kontaktfläche 48 parallel zueinander angeordnet. Ferner ist das zugeordnete Differential-Pair Kontaktpaar zwischen der zweiten steckerseitigen Kontaktfläche 19 und der zweiten steckerbuchsenseitigen Kontaktfläche 48 angeordnet.

Die erste steckerseitige Kontaktfläche 17, die zweite steckerseitige Kontaktfläche 19, die erste steckerbuchsenseitige Kontaktfläche 46 und die zweite steckerbuchsenseitige Kontaktfläche 44 bilden somit einen (Verbindungs-)Kanal, in welchem das Differential-Pair Kontaktpaar angeordnet ist bzw. welcher das Differential-Pair Kontaktpaar umgibt. Ferner können die erste steckerseitige Kontaktfläche 17, die zweite steckerseitige Kontaktfläche 19, die erste steckerbuchsenseitige Kontaktfläche 46 und die zweite steckerbuchsenseitige Kontaktfläche 48 in Richtung der Verbindungsrichtung V die gleiche Länge bzw. Abmessung aufweisen. Durch das Anordnen des Differential-Pair Kontaktpaars innerhalb des Kanals wird das Differential-Pair Kontaktpaar geschützt. Des Weiteren sind die erste steckerseitige Kontaktfläche 17, die zweite steckerseitige Kontaktfläche 19, die erste steckerbuchsenseitige Kontaktfläche 46 und die zweite steckerbuchsenseitige Kontaktfläche 44 sehr nah am jeweiligen Differential-Pair Kontaktpaar angeordnet, wodurch vorteilhafterweise der Rückstrom sehr nah an dem jeweiligen Differential-Pair Kontaktpaar geführt werden kann.

Wie in den Fig. 3 und 4 gezeigt, sind die den jeweils in einer Reihe angeordneten steckerseitigen Differential-Pair Kontaktelementen 14 zugeordneten ersten steckerseitige Kontaktflächen 17 jeweils an derselben Seite des zugehörigen steckerseitigen Differential-Pair Kontaktelements 14 angeordnet. Mit anderen Worten liegen die den jeweils in einer Reihe angeordneten steckerseitigen Differential-Pair Kontaktelementen 14 zugeordneten ersten steckerseitigen Kontaktflächen 17 jeweils in derselben Ebene. Bevorzugt sind die den jeweils in einer Reihe angeordneten steckerseitigen Differential-Pair Kontaktelementen 14 zugeordneten ersten steckerseitigen Kontaktflächen 17 als eine einzige zusammenhängende Kontaktfläche ausgebildet. Mit anderen Worten sind die in einer Reihe benachbarten ersten steckerseitigen Kontaktflächen 17 entlang der Längsrichtung A-A' des Steckers 10 unmittelbar miteinander verbunden. Davon ausgehend erstrecken sich die den jeweils in einer Reihe angeordneten steckerseitigen Differential-Pair Kontaktelementen 14 zugeordneten steckerseitige Kontaktflächen 19 jeweils senkrecht von der zusammenhängende Kontaktfläche. Dadurch kann das zweite Bezugspotentialkontaktelement 13 besonders stabil ausgebildet werden und Verformungen des zweiten Bezugspotentialkontaktelements 13, welche aus dem Verbinden von Stecker 10 und Steckerbuchse 40 resultieren können, werden wirksam verhindert.

Des Weiteren zeigen die Fig. 1 und 2, ein drittes Bezugspotentialkontaktelement 25 und 27, welches Bestandteil des Steckers 10 ist und einstückig mit diesem ausgebildet ist. Das dritte Bezugspotentialkontaktelement 25 und 27 dient einer möglichen elektrischen Stromrückführung insbesondere zum Sichern der Steckerbuchse 40 an dem Stecker 10, wenn der Stecker 10 und die Steckerbuchse 40 miteinander verbunden sind. Wie in den Fig. 1 und 2 gezeigt, kann das dritte Bezugspotentialkontaktelement ein erstes Sicherungselement 25 und ein zweites Sicherungselement 27 aufweisen, mit den die Steckerbuchse 40 am Stecker 20 gesichert wird. Das erste Sicherungselement 25 und das zweite Sicherungselement 27 sind jeweils an einem in der länglichen Richtung A-A' befindlichen Ende des Steckersockels 12 angeordnet, so dass das erste Sicherungselement 25 und das zweite Sicherungselement 27 gegenüberliegend angeordnet sind und der Steckersockel 12 zwischen dem ersten Sicherungselement 25 und dem zweiten Steckersockel 27 angeordnet ist.

**Fig. 6** veranschaulicht, wie der Stecker 10 mit der Steckerbuchse 40 verbunden werden kann. Zum Verbinden des Steckers 10 mit der Steckerbuchse 40, kann der Stecker 10 in Richtung der gezeigten Verbindungsrichtung V mit der Steckerbuchse 40 gekoppelt bzw. verbunden werden. Dabei sind der Stecker 10 und die Steckerbuchse 40 derart ausgebildet, dass das erste Bezugspotentialkontaktelement 24 in Kontakt mit dem Gehäuse 44 kommt bevor die Vielzahl von steckerseitigen Differential-Pair Kontaktelementen 14 in Kontakt mit der Vielzahl von steckerbuchsenseitigen Differential-Pair Kontaktelementen 42 gelangt.

### Bezugszeichenliste

- 10: Stecker
- 11: zweites Bezugspotentialkontaktelement
- 12: Steckersockel
- 13: steckerseitiger Kontakthohlraum
- 14: steckerseitiges Differential-Pair Kontaktelement
- 15: steckerseitiger Differential-Pair Isolierkörper
- 16: erstes elektrisches Verbindungselement
- 17: erste steckerseitige Kontaktfläche
- 18: zweites elektrisches Verbindungselement
- 19: zweite steckerseitige Kontaktfläche
- 20: Reihe aus steckerseitigen Differential-Pair Kontaktelementen
- 21: steckerseitige Vielzahl von Kontaktflächen
- 22: Spalte aus steckerseitigen Differential-Pair Kontaktelementen
- 24: erstes Bezugspotentialkontaktelement
- 25: erstes Sicherungselement
- 26: erste Seite des Bezugspotentialkontaktelements
- 27: zweites Sicherungselement
- 28: zweite Seite des Bezugspotentialkontaktelements
- 30: dritte Seite des Bezugspotentialkontaktelements
- 32: vierte Seite des Bezugspotentialkontaktelements
- 34: Verbindungsflächen
- 36: Verrastungselemente
- 38: Federelemente
- 40: Steckerbuchse
- 42: steckerbuchsenseitiges Differential-Pair Kontaktelement
- 43: Aussparung
- 44: Gehäuse
- 45: steckerbuchsenseitigen Vielzahl von Kontaktflächen
- 46: erste steckerbuchsenseitige Kontaktfläche
- 48: zweite steckerbuchsenseitige Kontaktfläche
- V: Verbindungsrichtung

## Patentansprüche

1. Stecker (10) zum Verbinden mit einer Steckerbuchse (40) zum Herstellen einer elektrischen Verbindung zwischen dem Stecker (10) und der Steckerbuchse (40) in einem Kraftfahrzeug, aufweisend:
- einen als Zinkdruckguss-Bauteil bereitgestellten Steckersockel (12), der eine Vielzahl von Kanälen mit rechteckigem Querschnitt aufweist, die sich jeweils in Verbindungsrichtung durch den Steckersockel (12) erstrecken;
- eine Vielzahl von steckerseitigen Differential-Pair Kontaktelementen (14) zum Herstellen der elektrischen Verbindung mit der Steckerbuchse (40), wobei jeder Kanal der Vielzahl von Kanälen dazu ausgebildet ist, jeweils einen steckerseitigen Differential-Pair Isolierkörper (15) mit einem daran angeordneten Paar der Vielzahl von steckerseitigen Differential-Pair Kontaktelementen (14) aufzunehmen, wobei jedes Paar der Vielzahl von steckerseitigen Differential-Pair Kontaktelementen (14) zum Leiten eines elektrischen Differenzsignals ausgebildet ist; und
- ein erstes elektrisch leitendes Bezugspotentialkontaktelement (24) zur Herstellung einer elektrischen Verbindung mit einem elektrischen Bezugspotential,
wobei das erste Bezugspotentialkontaktelement (24) von der Vielzahl von steckerseitigen Differential-Pair Kontaktelementen (14) elektrisch isoliert an dem Steckersockel (12) angeordnet ist,
wobei der Steckersockel (12) dazu ausgebildet ist, mit dem elektrischen Bezugspotential elektrisch verbunden zu sein,
wobei das erste Bezugspotentialkontaktelement (24) mit dem Steckersockel (12) elektrisch verbunden ist,
wobei das erste Bezugspotentialkontaktelement (24) als elektrische Abschirmung der Vielzahl von steckerseitigen Differential-Pair Kontaktelementen (14) ausgebildet ist, **dadurch gekennzeichnet, dass** das erste Bezugspotentialkontaktelement (24) ein Blechbauteil ist, welches die Vielzahl von steckerseitigen Differential-Pair Kontaktelementen (14) umgibt, und
wobei das erste Bezugspotentialkontaktelement (24) Verrastungselemente (36) aufweist, die dazu ausgelegt sind, mit komplementären Aufnahmeelementen des Steckersockels (12) in Eingriff zu gelangen, um das erste Bezugspotentialkontaktelement (24) formschlüssig mit dem Steckersockel (12) zu verbinden.

2. Stecker (10) gemäß Anspruch 1, wobei das erste Bezugspotentialkontaktelement (24) dazu ausgebildet ist, einen Rückstrom für die Vielzahl von steckerseitigen Differential-Pair Kontaktelementen (14) zu führen.

3. Stecker (10) gemäß Anspruch 1 oder 2, wobei das erste Bezugspotentialkontaktelement (24) dazu ausgebildet ist, elektrisch mit der Steckerbuchse (40) verbunden zu sein.

4. Stecker (10) gemäß einem der vorhergehenden Ansprüche, wobei der Steckersockel (12) als Zinkdruckguss-Bauteil ausgebildet ist und die Vielzahl von steckerseitigen Differential-Pair Kontaktelementen (14) von dem Steckersockel (12) elektrisch isoliert ausgebildet ist.

5. Stecker (10) gemäß einem der vorhergehenden Ansprüche, wobei jedes Paar der Vielzahl von steckerseitigen Differential-Pair Kontaktelementen (14) ein erstes elektrisch leitendes Verbindungselement (16) aufweist und ein zweites elektrisch leitendes Verbindungselement (18) zur Herstellung der elektrischen Verbindung mit der Steckerbuchse (40) aufweist, wobei das erste elektrisch leitende Verbindungselement (16) und das zweite elektrisch leitende Verbindungselement (18) parallel zueinander ausgebildet sind.

6. Stecker (10) gemäß einem der vorhergehenden Ansprüche, wobei die Vielzahl von steckerseitigen Differential-Pair Kontaktelementen (14) eine matrixförmige Anordnung, aufgeteilt in Reihen aus Differential-Pair Kontaktelementen (20) und Spalten aus Differential-Pair Kontaktelementen (22), aufweist.

7. Stecker (10) gemäß einem der vorhergehenden Ansprüche, wobei der Stecker (10) ein zweites Bezugspotentialkontaktelement aufweist (11).

8. Stecker (10) gemäß einem der vorhergehenden Ansprüche, wobei das erste Bezugspotentialkontaktelement (24) zumindest teilweise plattenförmig ausgebildet.

9. Stecker (10) gemäß einem der Ansprüche 5 bis 8, wobei das erste Bezugspotentialkontaktelement (24) parallel zu einer durch das erste elektrisch leitende Verbindungselement (16) und das zweite elektrisch leitende Verbindungselement (18) aufgespannten Bezugsebene ausgebildet ist.

10. Stecker (10) gemäß einem der Ansprüche 6-9, wobei das erste Bezugspotentialkontaktelement (24) parallel zu einer Reihe aus Differential-Pair Kontaktelementen (20) und/oder parallel zu einer Spalte aus Differential-Pair Kontaktelementen (22) angeordnet ist.

11. Stecker (10) gemäß einem der Ansprüche 6-10, wobei das erste Bezugspotentialkontaktelement (24) die matrixförmige Anordnung der Vielzahl von steckerseitigen Differential-Pair Kontaktelementen (14) umgibt.

12. Stecker (10) gemäß einem der vorhergehenden Ansprüche, wobei das erste Bezugspotentialkontaktelement (24) Federelemente (38) zum kraftschlüssigen Verbinden des ersten Bezugspotentialkontaktelement (24) mit der Steckerbuchse (40) aufweist.

13. Stecker (10) gemäß einem der Ansprüche 7-12, wobei das zweite Bezugspotentialkontaktelement (11) eine Vielzahl von steckerseitigen Kontaktflächen aufweist, und wobei jedem steckerseitigen Differential-Pair Kontaktelement (14) jeweils zwei verschiedene steckerseitige Kontaktflächen (17, 19) der Vielzahl von Kontaktflächen zugeordnet sind.

14. Verbindungssystem zum Herstellen einer elektrischen Verbindung zur Verwendung in einem Kraftfahrzeug, aufweisend:
- einen Stecker (10) gemäß einem der vorhergehenden Ansprüche; und
- eine mit dem Stecker (10) verbindbare Steckerbuchse (40), wobei die Steckerbuchse (40) eine zu der Vielzahl von steckerseitigen Differential-Pair Kontaktelementen (14) entsprechende Vielzahl von steckerbuchsenseitigen Differential-Pair Kontaktelementen (42) aufweist, und
wobei ein von der Vielzahl von steckerbuchsenseitigen Differential-Pair Kontaktelementen (42) elektrisch isoliertes Gehäuse (44) der Steckerbuchse (40) dazu ausgebildet ist, elektrisch mit dem ersten Bezugspotentialkontaktelement (24) verbunden zu sein.

## Claims

1. Plug (10) for connection to a socket (40) to establish an electrical connection between the plug (10) and the socket (40) in a motor vehicle, comprising:
- a plug base (12) provided as a zinc die-cast part that has a plurality of ducts with a rectangular cross section, which each extend through the plug base (12) in the connection direction;
- a plurality of plug-side differential pair contact elements (14) for establishing the electrical connection to the socket (40), wherein each duct of the plurality of ducts is configured to receive respectively a plug-side differential pair insulating body (15) with a pair of the plurality of plug-side differential pair contact elements (14) arranged thereon, wherein each pair of the plurality of plug-side differential pair contact elements (14) is configured to conduct an electrical differential signal; and
- a first electrically conductive reference potential contact element (24) for establishing an electrical connection to an electrical reference potential,
wherein the first reference potential contact element (24) is arranged on the plug base (12) electrically insulated from the plurality of plug-side differential pair contact elements (14),
wherein the plug base (12) is configured to be connected electrically to the electrical reference potential,
wherein the first reference potential contact element (24) is connected electrically to the plug base (12),
wherein the first reference potential contact element (24) is configured as an electrical shield of the plurality of plug-side differential pair contact elements (14), **characterised in that** the first reference potential contact element (24) is a sheet metal part, which encloses the plurality of plug-side differential pair contact elements (14), and
wherein the first reference potential contact element (24) comprises catch elements (36), which are configured to engage with complementary receiving elements of the plug base (12) in order to connect the first reference potential contact element (24) positively to the plug base (12).

2. Plug (10) according to claim 1, wherein the first reference potential contact element (24) is configured to carry a reverse current for the plurality of plug-side differential pair contact elements (14).

3. Plug (10) according to claim 1 or 2, wherein the first reference potential contact element (24) is configured to be connected electrically to the socket (40).

4. Plug (10) according to any one of the preceding claims, wherein the plug base (12) is formed as a zinc die-cast part and the plurality of plug-side differential pair contact elements (14) is electrically insulated from the plug base (12).

5. Plug (10) according to any one of the preceding claims, wherein each pair of the plurality of plug-side differential pair contact elements (14) has a first electrically conductive connection element (16) and a second electrically conductive connection element (18) for establishing the electrical connection to the socket (40), wherein the first electrically conductive connection element (16) and the second electrically conductive connection element (18) are formed parallel to one another.

6. Plug (10) according to any one of the preceding claims, wherein the plurality of plug-side differential pair contact elements (14) has a matrix arrangement, divided into rows of differential pair contact elements (20) and columns of differential pair contact elements (22).

7. Plug (10) according to any one of the preceding claims, wherein the plug (10) has a second reference potential contact element (11).

8. Plug (10) according to any one of the preceding claims, wherein the first reference potential contact element (24) is formed at least partially plate-shaped.

9. Plug (10) according to any one of claims 5 to 8, wherein the first reference potential contact element (24) is formed parallel to a reference plane stretched through the first electrically conductive connection element (16) and the second electrically conductive connection element (18).

10. Plug (10) according to any one of claims 6-9, wherein the first reference potential contact element (24) is arranged parallel to a row of differential pair contact elements (20) and/or parallel to a column of differential pair contact elements (22).

11. Plug (10) according to any one of claims 6-10, wherein the first reference potential contact element (24) encloses the matrix arrangement of the plurality of plug-side differential pair contact elements (14).

12. Plug (10) according to any one of the preceding claims, wherein the first reference potential contact element (24) has spring elements (38) for frictional connection of the first reference potential contact element (24) to the socket (40).

13. Plug (10) according to any one of claims 7-12, wherein the second reference potential contact element (11) has a plurality of plug-side contact surfaces, and wherein associated with each plug-side differential pair contact element (14) respectively are two different plug-side contact surfaces (17, 19) of the plurality of contact surfaces.

14. Connection system for establishing an electrical connection for use in a motor vehicle, comprising:
- a plug (10) according to any one of the preceding claims; and
- a socket (40) connectable to the plug (10), wherein the socket (40) has a plurality of socket-side differential pair contact elements (42) corresponding to the plurality of plug-side differential pair contact elements (14), and
wherein a housing (44) of the socket (40) that is electrically insulated from the plurality of socket-side differential pair contact elements (42) is configured to be connected electrically to the first reference potential contact element (24).

## Revendications

1. Fiche (10) destinée au raccordement avec un connecteur femelle (40) pour établir un raccordement électrique entre la fiche (10) et le connecteur femelle (40) dans un véhicule automobile, présentant :
- un socle de fiche (12) mis à disposition sous la forme d'un composant en zinc coulé sous pression, qui présente une pluralité de canaux à section transversale rectangulaire, qui s'étendent respectivement dans la direction de raccordement à travers le socle de fiche (12) ;
- une pluralité d'éléments de contact (14) de paire différentielle côté fiche pour établir le raccordement électrique avec le connecteur femelle (40), chaque canal de la pluralité de canaux étant conçu pour recevoir respectivement un corps isolant (15) de paire différentielle côté fiche avec, disposée sur celui-ci, une paire de la pluralité d'éléments de contact (14) de paire différentielle côté fiche, chaque paire de la pluralité d'éléments de contact (14) de paire différentielle côté fiche étant conçue pour conduire un signal électrique différentiel ; et
- un premier élément de contact de potentiel de référence (24) électriquement conducteur destiné à établir un raccordement électrique avec un potentiel électrique de référence,
le premier élément de contact de potentiel de référence (24) étant disposé sur le socle de fiche (12) de manière électriquement isolée de la pluralité d'éléments de contact (14) de paire différentielle côté fiche,
le socle de fiche (12) étant conçu pour être raccordé électriquement au potentiel électrique de référence,
le premier élément de contact de potentiel de référence (24) étant raccordé électriquement au socle de fiche (12),
le premier élément de contact de potentiel de référence (24) étant réalisé sous la forme d'un blindage électrique de la pluralité d'éléments de contact (14) de paire différentielle côté fiche, **caractérisée en ce que** le premier élément de contact de potentiel de référence (24) est un composant en tôle, qui entoure la pluralité d'éléments de contact (14) de paire différentielle côté fiche, et
le premier élément de contact de potentiel de référence (24) présentant des éléments d'enclenchement (36), qui sont configurés pour venir en prise avec des éléments de réception complémentaires du socle de fiche (12) pour raccorder le premier élément de contact de potentiel de référence (24) au socle de fiche (12) par complémentarité de forme.

2. Fiche (10) selon la revendication 1, dans laquelle le premier élément de contact de potentiel de référence (24) est conçu pour conduire un courant de retour pour la pluralité d'éléments de contact (14) de paire différentielle côté fiche.

3. Fiche (10) selon la revendication 1 ou 2, dans laquelle le premier élément de contact de potentiel de référence (24) est conçu pour être raccordé électriquement au connecteur femelle (40).

4. Fiche (10) selon l'une des revendications précédentes, dans laquelle le socle de fiche (12) est réalisé sous la forme d'un composant en zinc coulé sous pression et la pluralité d'éléments de contact (14) de paire différentielle côté fiche est réalisée de manière électriquement isolée du socle de fiche (12).

5. Fiche (10) selon l'une des revendications précédentes, dans laquelle chaque paire de la pluralité d'éléments de contact (14) de paire différentielle côté fiche présente un premier élément de raccordement (16) électriquement conducteur et un second élément de raccordement (18) électriquement conducteur pour établir le raccordement électrique avec le connecteur femelle (40), le premier élément de raccordement (16) électriquement conducteur et le second élément de raccordement (18) électriquement conducteur étant réalisés parallèlement l'un par rapport à l'autre.

6. Fiche (10) selon l'une des revendications précédentes, dans laquelle la pluralité d'éléments de contact (14) de paire différentielle côté fiche présente un agencement en forme de matrice, divisé en rangées d'éléments de contact de paire différentielle (20) et colonnes d'éléments de contact de paire différentielle (22).

7. Fiche (10) selon l'une des revendications précédentes, dans laquelle la fiche (10) présente (11) un second élément de contact de potentiel de référence.

8. Fiche (10) selon l'une des revendications précédentes, dans laquelle le premier élément de contact de potentiel de référence (24) est réalisé au moins en partie en forme de plaque.

9. Fiche (10) selon l'une des revendications 5 à 8, dans laquelle le premier élément de contact de potentiel de référence (24) est réalisé parallèlement à un plan de référence qui s'étend à travers le premier élément de raccordement (16) électriquement conducteur et le second élément de raccordement (18) électriquement conducteur.

10. Fiche (10) selon l'une des revendications 6 à 9, dans laquelle le premier élément de contact de potentiel de référence (24) est disposé parallèlement à une rangée d'éléments de contact de paire différentielle (20) et/ou parallèlement à une colonne d'éléments de contact de paire différentielle (22).

11. Fiche (10) selon l'une des revendications 6 à 10, dans laquelle le premier élément de contact de potentiel de référence (24) entoure l'agencement en forme de matrice de la pluralité d'éléments de contact (14) de paire différentielle côté fiche.

12. Fiche (10) selon l'une des revendications précédentes, dans laquelle le premier élément de contact de potentiel de référence (24) présente des éléments formant ressorts (38) pour le raccordement par adhérence du premier élément de contact de potentiel de référence (24) au connecteur femelle (40).

13. Fiche (10) selon l'une des revendications 7 à 12, dans laquelle le second élément de contact de potentiel de référence (11) présente une pluralité de surfaces de contact côté fiche et dans laquelle deux surfaces de contact (17, 19) côté fiche différentes de la pluralité de surfaces de contact sont respectivement associées à chaque élément de contact (14) de paire différentielle côté fiche.

14. Système de raccord pour établir un raccordement électrique destiné à être utilisé dans un véhicule automobile, présentant :
- une fiche (10) selon l'une des revendications précédentes ; et
- un connecteur femelle (40) qui peut être raccordé à la fiche (10), le connecteur femelle (40) présentant une pluralité d'éléments de contact (42) de paire différentielle côté connecteur femelle correspondant à la pluralité d'éléments de contact (14) de paire différentielle côté fiche, et
dans lequel un boîtier (44), isolé électriquement de la pluralité d'éléments de contact (42) de paire différentielle côté connecteur femelle, du connecteur femelle (40) est conçu pour être raccordé électriquement au premier élément de contact de potentiel de référence (24).
